Europäisches Patentamt

European Patent Office

Office européen des brevets

(19)

(11) Publication number: **0 110 635**
A1

# EUROPEAN PATENT APPLICATION

(21) Application number: 83307044.4

(22) Date of filing: 18.11.83

(51) Int. Cl.³: **H 01 B 13/16,** H 01 L 21/60, **H 01 R 43/02**

(30) Priority: 24.11.82 GB 8233459

(43) Date of publication of application: 13.06.84
Bulletin 84/24

(84) Designated Contracting States: **AT BE CH DE FR GB IT
LI LU NL SE**

(71) Applicant: **PRUTEC LIMITED, 142 Holborn Bars, London
EC1N 2NH (GB)**

(72) Inventor: **Jasper, Francis Emile, Rue de Llernu, 8,
B-5854 La Bruyere (BE)**
Inventor: **Peeters, Josephus Bonifacius,
Maachtstraat 136A, B-3008 Beltem-Beisem (BE)**
Inventor: **Sierens, Willy Michel, Electriciteitstraat 31,
Mechelen (BE)**

(74) Representative: **Messulam, Alec Moses, A. Messulam &
Co. 24 Broadway, Leigh on Sea Essex SS9 1BN (GB)**

(54) **Wire bonding.**

(57)    The invention relates to a method of wire bonding in which
the wire is coated with a polymerisable material which is cured by
exposure to radiation after the wire bond has been formed. In this
way the wire is insulated so as to enable a higher interconnection
density without risk of short circuit.

   The invention also relates to apperatus for putting the above
method into practice. The bonding wire passes through a capil-
lary tube (10') in the base of a reservoir (40) filled with the
polymerisable material. In this way the wire is coated but the liquid
does not escape from the reservoir (40).

- 1 -    0110635

## WIRE BONDING

The present invention relates to wire bonding this being a process for connecting two adjacent conductors by means of a wire bridge. Such wire bonding is effected, for example, to provide an electrical connection between a component such as a semiconductor chip mounted on a substrate and an adjacent electrical conductor on the substrate.

When a silicon chip is produced, it is provided on its surface with contact pads to which it is necessary to make electrical connection. If the silicon chip is, for example, an integrated circuit to be mounted within a dual in-line package then the chip is secured to the base of the package and wire bridges are formed between the contact pads on the semiconductor chip and the contact pins of the package.

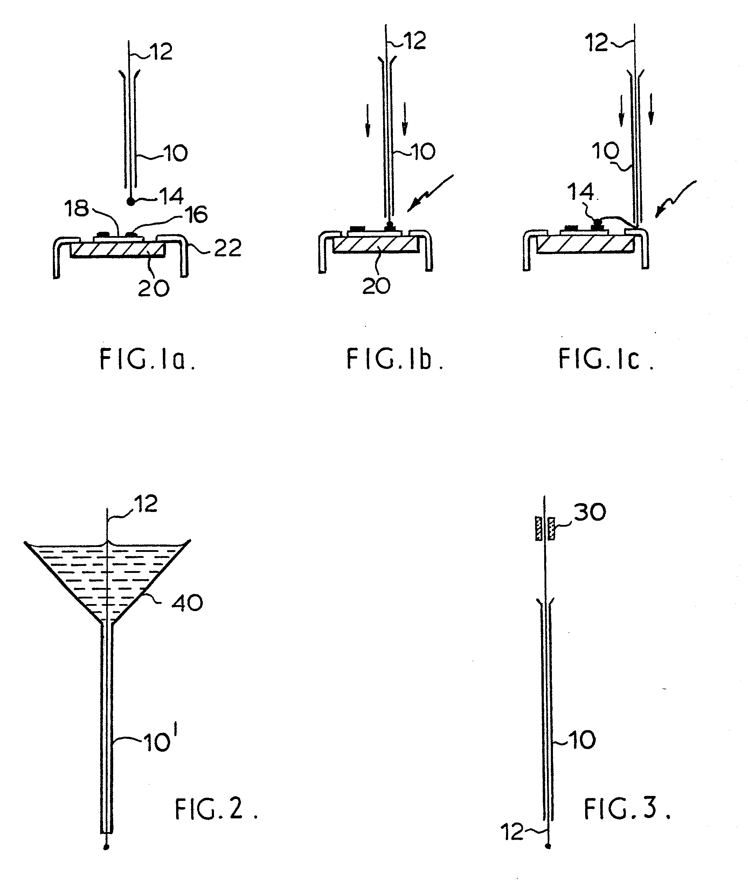

Figure 1 shows a known method of producing such an electrical bridge. In Figure 1a, there is shown a dispensing tube in the form of a capillary tube 10 through which passes a fine wire 12. The end of the wire 12 will have previously been formed into a ball 14 by the application of heat, as mentioned below. The ball 14 is brought to rest on a contact pad 16 of a semiconductor chip 18 supported, as shown in Figure 1b, on the base of a package 20 having contact pins 22 to be connected to the contact pads 16 on the chip 18. With the ball 14 resting on the contact pad 16, energy is applied, in the form of heat or ultra-sound, to create a bond. Following the making of this bond, the dispensing tube 10 is re-aligned, while viewed by microscope, with a contact pin 22, as shown in Figure 1c, and a second bond is made. After completion of the second bond, the bonding wire 12 is melted to sever the wire leaving the electrical bridge in position and simultaneously forming a new ball 14 on the end of the wire 12.

When a bridge is formed by the method described above, because the bonding wire is bare, there is a risk of bonding wires making contact with each other and creating a short circuit. For this reason, it is usual to form the contact pads only about the periphery of a semiconductor chip and to use only short taut wires for the electrical bridges. This places a constraint on the design and manufacture of the semiconductor chip in that the number of pads and their location cannot be chosen at will.

The present invention seeks to provide a method of wire bonding which mitigates a least some of the foregoing disadvantages.

In accordance with the first aspect of the present invention, there is provided a method of wire bonding in which a wire is bonded by applying pressure and energy while the wire is resting on the contact area, characterised in that prior to the formation of the bonds, the wire is coated with a polymerisable liquid, and after the formation of the bonds, the wire is exposed to radiation to cure the liquid and form a hard insulating coating on the wire.

In accordance with a second aspect of the invention, there is provided wire bonding apparatus characterised by means for applying a polymerisable material to the bonding wire prior to the formation of the bonds and means for irradiating the wire after the formation of the bonds in order to cure the polymerisable material and form an insulating coating on the wire.

- 3 -                              0110635

The invention will now be described further, by way of example, with reference to the accompanying drawings, in which :

Figures la, lb and lc show, as previously described, different stages in the formation of a wire bond in a conventional manner, and

Figures 2 and 3 show details of a dispensing tube of a wire bonding machine of the invention.

In Figure 2, there is shown a modified capillary tube 10' which is formed at its upper end with a funnel-like reservoir 40 containing a photo-polymerisable material. Because of the viscosity of the material, there is no escape of fluid through the capillary tube 10'. However, as the bonding wire 12 is drawn through the capillary tube 10' it is coated with a thin layer of the photo-polymerisable material which distributes itself evenly over the surface of the wire. The uncured material, in liquid form, does not interfere with the bonding process previously described since the application of pressure will result in the liquid film being displaced from the contact area. However, after the bonds which form the bridge have been completed, it is possible to expose the wire to ultraviolet light to cure the photo-polymerisable material and produce a hard electrically insulating coating which removes the risk of short circuits.

This can now allow bonding wires to cross if necessary thereby alleviating considerably the constraints placed on designers of semiconductor chips as to the position for forming the contact pads.

Another advantage of the use of the insulated wires is that it enables an inductor or a transformer to be formed directly on a printed circuit. For example, an annular core may be positioned on a printed circuit to overlie a set of parallel conductors. Wire bonds may now be formed connecting the opposite ends of adjacent conductors by bridges which pass over the top of the core. When all the conductors are interconnected in this manner they constitute in conjunction with the bridges a coil wrapped around the core. Two coils may be formed in this manner around the same coil to form a transformer and, if desired, the core may be annular.

As an alternative to the use of the capillary tube 10' as part of a container for the photo-polymerisable material, it is possible to add to a conventional bonding apparatus any convenient means for coating the wire with a photo-polymerisable material prior to its entering the capillary tube 10. Thus, in Figure 3, there is positioned immediately above the conventional capillary tube 10 a pair of pads 30 which are soaked in the photo-polymerisable material.

As a further alternative, in place of the pads fine-haired brushes or of fine spray may be utilised to provide the wire with the necessary coating prior to its entering the capillary tube 18.

The main components of the photo-polymerisable material are a prepolymer, a monomer, a photoinitiator and a photoactivator. However, care must also be taken to ensure that the photo- polymerisable material forms an even coating over the surface of the wire and does not form droplets. When the material tails on the surface of the wire, parts of the wire remain bare giving rise to a risk of short circuit.

To assist in forming an even coating, a surfactant additive is preferably included in the composition of the photo-polymerisable material to promote wetting, and it is also preferred to include a thixotropic additive.

The advantage of providing a prepolymer mixed with the monomer is that it enables more rapid photo-polymerisation while the nature and the concentration of the prepolymer determine to a great extent the properties of the polymer coating. The prepolymer may conveniently be chosed from the group comprising polyol acrylates, urethane acrylates, epoxy acrylates, straight acryls, polyester acrylates, polyether acrylates and melamine acrylates.

The monomer serves to provide the appropriate rheology for the polymer and can be selected to give fast curing time and a high degree of cross linking. The prepolymer should be soluble in the monomer. Depending upon the properties desired, the monomer may be selected from amongst monoacrylates, diacrylates and triacrylates.

The photoinitiator is provided for the purpose of absorbing ultra-violet photons and forming one or more radicals which are sufficiently reactive to initiate the polymerisation. Most acrylic prepolymers and monomers do not absorb UV photons sufficiently to initiate a fast polymerisation independently. The photoinitiator may employ one of several mechanisms namely homolytic fission (eg benzoin), hydrogen abstraction (eg benzophenones) and electron transfer.

For film thicknesses below 50 microns, oxygen inhibition of polymerisation at the surface becomes noticeable and the photoactivator is provided to overcome this problem. Typically, the photoactivator is a tertiary aliphatic amine, two suitable classes of amines being ethanolamine and amino acrylates.

A suitable surfactant which may be employed is FC-430 (3M) and the thixotropic agent may be an asbestos based agent such as SYLODEX 14 (Grace).

A photo-polymer composition foud to have suitable properties was made from a mixture of the following constituents:

1. an epoxy-acrylate pre-polymer, purchased from UCB (Belgium) under trade name EBECRYL 600 which is the principle component in the final cured resin,

2. a polyol polyacrylate monomer, purchased from UCB (Belgium) under the trade name HDDA, which acts as a viscosity modifier in the uncured state,

3. a photoinitiator, UVECRYL P36, supplied by UCB (Belgium), which promotes polymerisation,

4. UVECRYL P104 photoactivator, supplied by UCB (Belgium).

5. FC-430, a surfactant supplied by 3M, which promotes wetting, and

6. SYLODEX 14, a thixo tropic agent supplied by Grace.

In order to assist further in ensuring an even coating, it is desirable to reduce the temperature of the material after it has been coated onto the wire in order to increase its viscosity and thus reduce the tendency to form droplets. This may conveniently be achieved by heating the capillary tube and using a composition which is viscous under normal temperatures. The outer surface of the capillary tube, which is normally made of a ceramic material, may have a printed conductor formed thereon to act as a heating element connected to a power supply in order to heat the tube. As soon as the wire leaves the capillary tube, its temperature drops and cools the coating on the wire to prevent it flowing.

A still further step to improve the evenness of the coating is to subject the coating to a partial curing by exposure to radiation immediately on leaving the capillary tube and before it has been bonded. The partial curing prevents the material from forming droplets but does not interfere with the subsequent formation of the bonds.

If this measure is taken, it is important to ensure that the material in the tube is not polymerised by the radiation as this would cause the capillary tube to be blocked. To achieve such partial polymerisation, the wire is illuminated at a point immediately beneath the tip of the capillary tube, the point of illumination moving with the tube.

The optical system for achieving such partial curing may comprise a light source providing a collimated light beam extending parallel to the substrate to which bonding is being effected. To prevent polymerisation at the tip of the capillary tube, a shutter may be provided coupled for movement with the capillary tube such that the tube always remains within the shadow of the shutter. The collimated light beam may, for example, be provided by a fibre optic bundle of which the end adjacent the capillary tube is shaped into a rectangle.

The above method of illumination has the advantage that apart from the shutter the optical system is stationary and can therefore be included in a conventional wire bonding machine without major modification. However, the light may alternatively be focused at a point just below the tip of the capillary tube by means of an optical system movable with the bonding machine. While such an optical system may be integrated into a purposely designed wire bonding machine it is more difficult to implement by modification of existing equipment.

To form a wire bond using the two stage curing process, the capillary tube is raised from the substrate after the first bond is formed and simulatneously the illumination source is energised to cure the polymerisable the material partially as it is being withdrawn from the tube. The illumination source for the partial curing is preferable a mercury-xenon arc lamp which gives an intense light which may be imaged onto the wire.

The tip of the tube is placed over the location of the second bond and pressure is applied in the usual manner to form a bond. After severing of the wire, the partially cured material is again exposed to radiation to harden the insulation fully.

The means for irradiating the applied coating to bring about complete curing may comprise a continuous source of UV light provided with a suitable shuttering system. Alternatively, a powerful flash may be employed. In either case, the light source may be positioned either adjacent the wire to be insulated, or it may be positioned remotely and the light guided to the wire by means of a fibre optic light guide.

In addition to the advantages mentioned previously, the invention can enable increased interconnection densities to be achieved, provide increased yield and, in some cases, permit smaller wires to be used, for example in hybrid circuits.

## CLAIMS

1.    A method of wire bonding in which a wire is bonded by applying pressure and energy while the wire is resting on the contact area, characterised in that prior to the formation of the bonds, the wire is coated with a polymerisable liquid, and after the formation of the bonds, the wire is exposed to radiation to cure the liquid and form a hard insulating coating on the wire.

2.    A method as claimed in claim 1, wherein the polymerisable liquid is photo-polymerisable and comprises :

    1.  an epoxy-acrylate pre-polymer,

    2.  a polyol polyacrylate monomer,

    3.  a photoinitiator, and

    4.  a photoactivator.

3.    A method as claimed in claim 2, wherein the polymerisable material additionally comprises a surfactant, and a thixotropic agent.

4.    A method as claimed in claim 1, 2 or 3, wherein the polymerisable liquid on the wire is partially cured before formation of the bonds in order to inhibit the formation of liquid droplets.

5.    A wire bonding apparatus, characterised by means (30, 40) for applying a polymerisable material to the bonding wire (12) prior to the formation of the bonds and means for irradiating the wire after the formation of the bonds in order to cure the polymerisable material and form an insulating coating on the wire.

6. A wire bonding apparatus as claimed in claim 5, comprising a fine tube (10) for dispensing the bonding wire (12) and means (30, 40) for applying a coating of polymerisable material to the wire prior to entering the fine tube.

7. A wire bonding apparatus as claimed in claim 6, wherein the means for coating the wire comprises a reservoir (40) positioned at the upper end of the tube.

8. A wire bonding apparatus as claimed in claim 6 or 7, wherein the fine tube is provided with heating means, whereby the polymerisable material cools on leaving the tube.

9. A wire bonding apparatus as claimed in any one of claims 5 to 8, wherein means are provided for irradiating the coating on the bonding wire prior to bonding to cause partial curing of the material prior to the formation of the bonds.

10. A wire bonding apparatus as claimed in claim 9, wherein the means for irradiating the wire comprises means for imaging a light source onto the wire, the image being movable with tube such the the tip of the tube always remains above the point of illumination.

1-1

0110635

FIG.1a.

FIG.1b.

FIG.1c.

FIG.2.

FIG.3.

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | EP-A-0 009 312 (HILKER)<br>* Claims 1,3,5,7,8,10,11; page 11, line 28 - page 12, line 26; page 14, line 34 - page 17, line 3; figures 1,2 * | 1,4-8 | H 01 B 13/16<br>H 01 L 21/60<br>H 01 R 43/02 |
| | --- | | |
| A | US-A-4 298 630 (KAPUSCINSKI et al.)<br>* Column 1, line 62 - column 3, line 26; figures 1-3 * | 1-6 | |
| | --- | | |
| A | FR-A-2 346 827 (WESTINGHOUSE)<br>* Claims 1,3,4,16; figure 2 * | 1,2 | |
| | --- | | |
| A | US-A-4 266 710 (BILANE et al.)<br><br>* Column 6, line 22 - column 7, line 47; figure 8 * | | |
| | ----- | | |

TECHNICAL FIELDS SEARCHED (Int. Cl. ³)

H 01 B 13/16
H 01 L 21/60
H 01 R 4/02
H 01 R 43/02

The present search report has been drawn up for all claims

| Place of search<br>BERLIN | Date of completion of the search<br>17-02-1984 | Examiner<br>HAHN G |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82